(19) **Europäisches Patentamt / European Patent Office / Office européen des brevets**

(11) **EP 3 889 684 A1**

(12) **EUROPEAN PATENT APPLICATION**

(43) Date of publication:
06.10.2021 Bulletin 2021/40

(51) Int Cl.:
*G03F 7/20* (2006.01)    *G01N 21/956* (2006.01)
*G06T 7/00* (2017.01)

(21) Application number: 20167449.6

(22) Date of filing: 01.04.2020

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **PISARENCO, Maxim**
**5500 AH Veldhoven (NL)**
• **MIDDLEBROOKS, Scott Anderson**
**5500 AH Veldhoven (NL)**
• **HUISMAN, Thomas Jarik**
**5500 AH Veldhoven (NL)**

(74) Representative: **ASML Netherlands B.V.**
**Corporate Intellectual Property**
**P.O. Box 324**
**5500 AH Veldhoven (NL)**

(54) **REMOVING AN ARTEFACT FROM AN IMAGE**

(57)    An inspection tool comprising:
an imaging system configured to image a portion of a semiconductor substrate; and
an image analysis system configured to:
obtain an image of a structure on the semiconductor substrate from the imaging system;
encode the image of the structure into a latent space thereby forming a first encoding;
subtract an artefact vector, representative of an artefact in the image, from the encoding thereby forming a second encoding; and
decode the second encoding to obtain a decoded image.

## Fig. 5

**Description**

FIELD

The present disclosure relates to methods for processing images of semiconductor substrates, in particular for device manufacturing using lithographic apparatus.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

Most semiconductor devices require a plurality of pattern layers to be formed and transferred onto the substrate. For proper functioning of the device, there is usually a limit on the tolerable error in the positioning of edges, quantified in an edge placement error or EPE. EPE can arise because of errors in the relative positioning of successive layers, known as overlay, or due to errors in the dimensions (specifically the critical dimension or CD) of features. With the continual desire in the lithographic art to reduce the size of features that can be formed (shrink), the limits on EPE are becoming stricter.

Overlay can arise from a variety of causes in the lithographic process, for example errors in the positioning of the substrate during exposure and aberrations in the projected image. Overlay can also be caused during process steps, such as etching, which are used to transfer the pattern onto the substrate. Some such process steps generate stresses within the substrate that lead to local or global distortions of the substrate. The formation of three dimensional structures on the substrate, such as is required for recently developed memory types and MEMS, can also lead to significant distortions of the substrate. CD variation can also derive from a variety of causes, including dose or focus errors.

SUMMARY

The present disclosure aims to enable more accurate metrology, e.g. for use in lithographic device manufacturing processes.

According to an embodiment there is provided a method for removing an artefact from an image of a semiconductor substrate, the method comprising:

    obtaining an image of a structure on the semiconductor substrate;
    encoding the image of the structure into a latent space thereby forming a first encoding;
    subtracting an artefact vector, representative of an artefact in the image, from the encoding thereby forming a second encoding; and
    decoding the second encoding to obtain a decoded image.

According to an embodiment there is provided an inspection tool comprising: an imaging system configured to image a portion of a semiconductor substrate; and an image analysis system configured to:

    obtain an image of a structure on the semiconductor substrate;
    encode the image of the structure into a latent space thereby forming a first encoding;
    subtract an artefact vector, representative of an artefact in the image, from the encoding thereby forming a second encoding; and
    decode the second encoding to obtain a decoded image.

A method of manufacture of a semiconductor substrate, the method comprising the steps of:

    manufacturing at least part of the semiconductor substrate;
    obtaining an image of a structure on the semiconductor substrate;
    encoding the image of the structure into a latent space thereby forming a first encoding;
    subtracting an artefact vector, representative of an artefact in the image, from the encoding thereby forming a second encoding;

decoding the second encoding to obtain a decoded image;

analyzing the decoded image to obtain a metric of the image;

comparing the metric to a target metric and taking remedial action when the metric does not meet the target metric.

BRIEF DESCRIPTION OF THE DRAWINGS/FIGURES

Embodiments will now be described, by way of example, with reference to the accompanying drawings in which:

Figure 1 depicts a lithographic apparatus together with other apparatuses forming a production facility for semiconductor devices;

Figures 2A and 2B depict images of a semiconductor substrate with different levels of artefacts present therein;

Figures 3A and 3B depict images of semiconductor substrates and illustrate how artefacts present therein result in measurement error;

Figures 4A and 4B show graphs demonstrating how increasing the number of frames used in SEM imaging impacts the CD measured;

Figure 5 depicts a method for removing an artefact in accordance with an embodiment;

Figure 6 is a flowchart depicting a method for removing an artefact in accordance with an embodiment;

Figure 7 is a flowchart depicting a method for determining an artefact vector for use in the method shown in Figure 6;

Figure 8 is a flowchart depicting a method for determining an artefact strength for use in the method shown in Figure 7;

Figure 9 is a graph illustrating the latent space with the artefact vector depicted thereon; and

Figures 10A and 10B depict images of a semiconductor substrate with an artefact present therein and with the artefact removed by a method of the present disclosure, respectively.

DETAILED DESCRIPTION

Electronic devices are constructed of circuits typically formed on a piece of silicon called a substrate, which may be referred to as a semiconductor substrate. Of course any other suitable material may be used for the substrate. Many circuits may be formed together on the same piece of silicon and are called integrated circuits or ICs. The size of these circuits has decreased dramatically so that many more of them can fit on the substrate. For example, an IC chip in a smartphone can be as small as a thumbnail and yet may include over 2 billion transistors, the size of each transistor being less than 1/1000th the size of a human hair.

Making these extremely small ICs is a complex, time-consuming, and expensive process, often involving hundreds of individual steps. Errors in even one step have the potential to result in defects in the finished IC, rendering it useless. Thus, one goal of the manufacturing process is to avoid such defects to maximize the number of functional ICs made in the process; that is, to improve the overall yield of the process.

One component of improving yield is monitoring the chip-making process to ensure that it is producing a sufficient number of functional integrated circuits. One way to monitor the process is to inspect the chip circuit structures at various stages of their formation. Inspection can be carried out using a scanning electron microscope (SEM), an optical inspection system, etc. Such systems can be used to image these structures, in effect, taking a "picture" of the structures of the wafer, with a SEM being able to image the smallest of these structures. The image can be used to determine if the structure was formed properly in the proper location. If the structure is defective, then the process can be adjusted, so the defect is less likely to recur.

In order to control errors in a lithographic manufacturing process, such as errors in the relative position of features in different layers (known as overlay) and the size of features (known as CD variation), it is necessary to measure the errors, such as by use of a scanning electron microscope (SEM), an optical inspection system, etc., before corrections can be applied. When using a SEM or other inspection system, images of the substrate are typically obtained and the size of features on the substrate are measured from the images. This allows, for example, determination of CD variation or EPE. However, the images obtained by the imaging techniques often comprise artefacts therein which can negatively impact the measurement of features therein. For example, when using a SEM, charging of the substrate can occur. This charging may be apparent on the images of the substrate, and can cause blurring of the features thereon. As a result, measurement of the features may not be wholly accurate and thus the charging may introduce an error in the measurements. Given the small tolerances in the measurements of the features on such substrates, errors of this type are less than desirable. Other artefacts which may be present in an image of a substrate, and thereby potentially cause errors in the measurement of features on the substrate, include noise and SEM-induced resist shrinkage. Disclosed below are new methods for the removal of artefacts or other undesirable image elements that enable more accurate measurements of features on the substrate.

Some methods disclosed herein process an image of a semiconductor substrate, which may have artefacts present therein, by encoding the image into a latent space, removing the artefacts in the latent space and decoding the encoding to reproduce the image with the artefacts removed. This advantageously produces an image with the artefacts removed therefrom which may then go on to be analyzed to determine the measurements of features of the image. The measurements of images with the artefacts removed therefrom will be more accurate. This improved accuracy may ensure that appropriate action is taken in the manufacturing process thus potentially maximizing the yield of the process. The lower dimensionality of the latent space compared to the dimensionality of the input space, i.e. the original images, may allow the artefacts to be removed more easily. Further, the inherent descriptive structure of a latent space may allow the identification of artefact-specific fingerprints more easily in the latent space, when compared to identifying such artefacts in the input space.

Before describing embodiments in detail, it is instructive to present an example environment in which the techniques disclosed herein may be implemented.

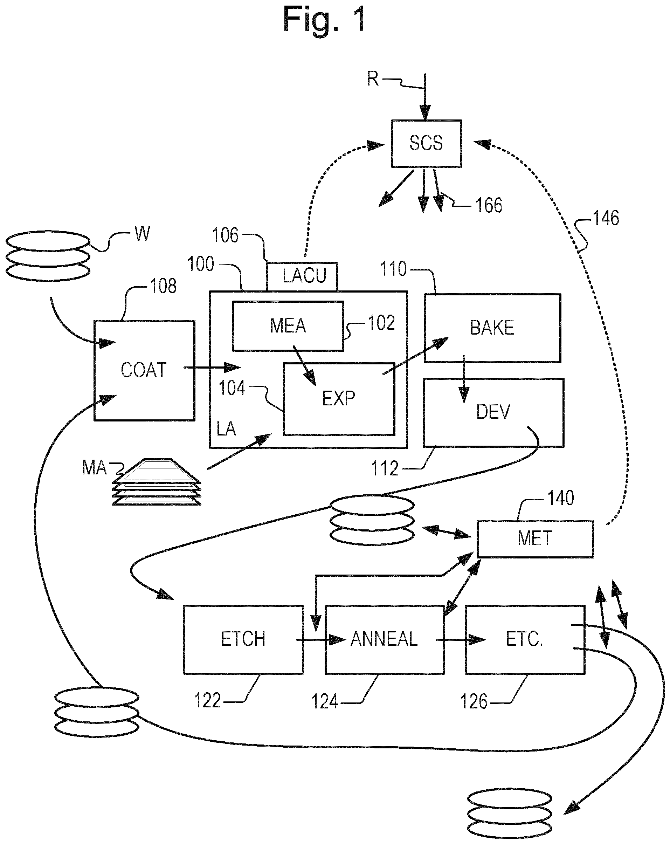

Figure 1 illustrates a typical layout of a semiconductor production facility. A lithographic apparatus 100 applies a desired pattern onto a substrate. A lithographic apparatus is used, for example, in the manufacture of integrated circuits (ICs). In that instance, a patterning device MA, which is alternatively referred to as a mask or a reticle, comprises a circuit pattern of features (often referred to as "product features") to be formed on an individual layer of the IC. This pattern is transferred onto a target portion (e.g., comprising part of, one, or several dies) on a substrate 'W' (e.g., a silicon wafer) via exposure 104 of the patterning device onto a layer of radiation-sensitive material (resist) provided on the substrate. In general, a single substrate will contain a network of adjacent target portions that are successively patterned.

Known lithographic apparatus irradiate each target portion by illuminating the patterning device while synchronously positioning the target portion of the substrate at an image position of the patterning device. An irradiated target portion of the substrate is referred to as an "exposure field", or simply "field". The layout of the fields on the substrate is typically a network of adjacent rectangles or other shapes aligned in accordance to a Cartesian two-dimensional coordinate system (e.g. aligned along an X and an Y-axis, both axes being orthogonal to each other).

A requirement on the lithographic apparatus is an accurate reproduction of the desired pattern onto the substrate. The positions and dimensions of the applied product features need to be within certain tolerances. Position errors may give rise to an overlay error (often referred to as "overlay"). The overlay is the error in placing a first product feature within a first layer relative to a second product feature within a second layer. The lithographic apparatus reduces the overlay errors by aligning each wafer accurately to a reference prior to patterning. This is done by measuring positions of alignment marks which are applied to the substrate. Based on the alignment measurements, the substrate position is controlled during the patterning process in order to prevent occurrence of out of tolerance overlay errors. Alignment marks are typically created as part of the product image, forming the reference to which overlay is measured. Alternatively, alignment marks of a previously formed layer can be used.

An error in a critical dimension (CD) of the product feature may occur when the applied dose associated with the exposure 104 is not within specification. For this reason the lithographic apparatus 100 must be able to accurately control the dose of the radiation applied to the substrate. The exposure 104 is controlled by the measurement tool 102 which is integrated into the lithographic apparatus 100. CD errors may also occur when the substrate is not positioned correctly with respect to a focal plane associated with the pattern image. Focal position errors are commonly associated with non-planarity of a substrate surface. The lithographic apparatus reduces these focal position errors by measuring the substrate surface topography using a level sensor prior to patterning. Substrate height corrections are applied during subsequent patterning to assure correct imaging (focusing) of the patterning device onto the substrate.

To verify the overlay and CD errors associated with the lithographic process, the patterned substrates are inspected by a metrology apparatus 140. Common examples of a metrology apparatus are scatterometers and scanning electron microscopes. The scatterometer conventionally measures characteristics of dedicated metrology targets. These metrology targets are representative of the product features, except that their dimensions are typically larger in order to allow accurate measurement. The scatterometer measures the overlay by detecting an asymmetry of a diffraction pattern associated with an overlay metrology target. Critical dimensions are measured by analysis of a diffraction pattern associated with a CD metrology target. A CD metrology target is used for measuring the result of the most recently exposed layer. An overlay target is used for measuring the difference between the positions of the previous and most recent layers. An electron beam (e-beam) based inspection tool, such as a scanning electron microscope (SEM), may be well suited for the measurement of small overlay and CD values.

Within a semiconductor production facility, lithographic apparatus 100 and metrology apparatus 140 form part of a "litho cell" or "litho cluster". The litho cluster comprises also a coating apparatus 108 for applying photosensitive resist to substrates W, a baking apparatus 110, a developing apparatus 112 for developing the exposed pattern into a physical resist pattern, an etching station 122, apparatus 124 performing a post-etch annealing step and possibly further processing apparatuses, 126, etc.. The metrology apparatus is configured to inspect substrates after development at development apparatus 112, or after further processing (e.g. etching at etching station 122). The various apparatus within the litho cell are controlled by a supervisory control system SCS, which issues control signals 166 to control the lithographic apparatus via lithographic apparatus control unit LACU 106 to perform recipe R. The SCS allows the different apparatuses to be operated giving maximum throughput and product yield. An important control mechanism is the feedback 146 of the metrology apparatus 140 to the various apparatus (via the SCS), in particular to the lithographic apparatus 100. Based on the characteristics of the metrology feedback, corrective actions are determined to improve processing quality of subsequent substrates. The SCS can be one computer or multiple computers, which may or may not communicate. The recipe R can be implemented as one recipe or as multiple independent recipes. For example, the recipe for a process step such as etch may be totally independent of the recipe to inspect the result of that process step (e.g. etch). For example, two or more recipes for individual steps may be interrelated such that one recipe is adjusted to take account of the results of performance of another recipe on the same or a different substrate.

The performance of a lithographic apparatus is conventionally controlled and corrected by methods such as advanced process control (APC) described for example in US2012008127A1. The advanced process control techniques use measurements of metrology targets applied to the substrate. A Manufacturing Execution System (MES) schedules the APC measurements and communicates the measurement results to a data processing unit. The data processing unit translates the characteristics of the measurement data to a recipe comprising instructions for the lithographic apparatus. This method is very effective in suppressing drift phenomena associated with the lithographic apparatus.

The processing of metrology data to corrective actions performed by the processing apparatus is important for semiconductor manufacturing. In addition to the metrology data, characteristics of individual patterning devices, substrates, processing apparatus and other context data may be needed to further optimize the manufacturing process. The framework wherein available metrology and context data is used to optimize the lithographic process as a whole is commonly referred to as part of holistic lithography. For example, context data relating to CD errors on a reticle may be used to control various apparatus (lithographic apparatus, etching station) such that said CD errors will not affect the yield of the manufacturing process. Subsequent metrology data may then be used to verify the effectiveness of the control strategy and further corrective actions may be determined.

To qualify the process window, separate CD and overlay measurements are performed with one or more of the existing tools and combined into an edge placement error (EPE) budget. Often, one metrology step might be performed after development (ADI) and another after an etch step (AEI), and there are inherent difficulties in calibrating two such different measurements to give equivalent results.

EPE is very important to ensure that a semiconductor device is working properly and, for example, it may affect whether, in a back end of line module, there is sufficient electrical contact. This makes EPE measurements very valuable to ensuring that the process window accommodates a sufficient EPE budget and to controlling the process to remain within window.

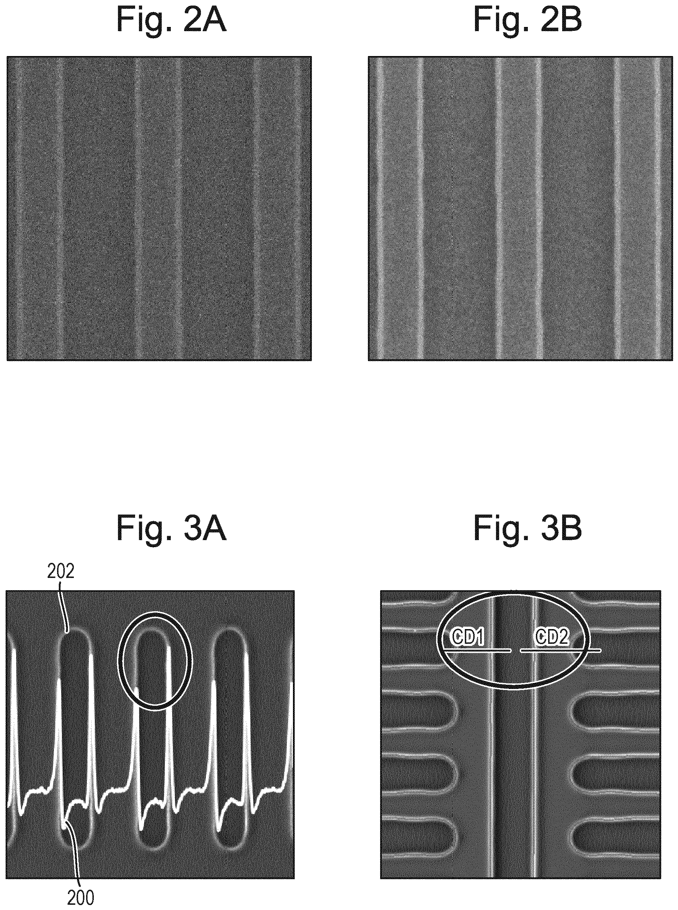

Figures 2A and 2B show examples of SEM-images with different amounts of noise, i.e. one exemplary type of artefact, present therein. The two images are taken at two different locations on the semiconductor substrate, where it is presumed that the locations have an identical structure thereon. The image shown in Figure 2A has more noise than the image shown in Figure 2B. The result of the increased noise level is that the contrast in the image shown in Figure 2A is worse than the image shown in Figure 2B which has less noise. The source of noise in an SEM-image may be a contribution of a number of different factors including: primary electron noise from electrons from the SEM gun, secondary electron noise from electrons scattered by the sample and detector noise due to the dark current noise in the detector. The detector noise may also comprise a contribution from amplification of the signal. As mentioned previously, the presence of artefacts, in this instance noise, may cause errors in the measurement of structures in the image. In the examples shown in Figures 2A and 2B, the noise in the images may cause measurements of the lines to be wider than they in fact are.

Figures 3A and 3B show examples of SEM-images with SEM-induced charging artefacts present therein. In Figure 3A, the SEM signal 200 is shown overlaying the SEM image. As is visible in Figure 3A, the SEM signal 200 is asymmetric within, and immediately, outside the slots 202. This asymmetry is attributed to SEM-induced charging of the substrate, as the slots 202 are known to be symmetric. Nonetheless, with the asymmetry present in the image it is difficult to accurately measure the features in the image. Figure 3B is a SEM-image intended for use in tip-to-line measurement. Such measurements are known to be impacted by the order of 2 nm due to SEM-induced charging. As the dimensions of structures, i.e. features, on a semiconductor substrate are typically very small, for example of the order of tens of nanometers, , a 2 nm error represents a significant portion of the measured dimension.

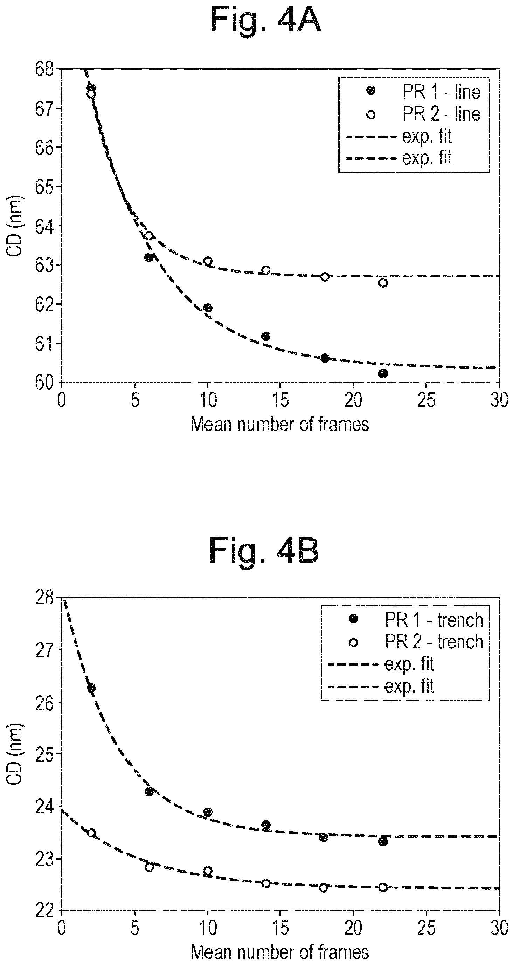

Figures 4A and 4B are graphs each showing two different examples in which a resist line-space CD changes as the number of SEM frames averaged to obtain the measurement of the CD is increased. Figure 4A shows the CD measurements for two lines, each manufactured from a different photoresist. Figure 4B shows the CD measurements for two trenches, each formed from a different photoresist. An exponential line is fit to both sets of data in each of the Figures. As apparent in both Figures 4A and 4B, as the mean number of frames is increased, the CD reduces. As shown, the CD varies significantly, in Figure 4A for example from around 67.5 nm down to 60/63 nm. This is a relatively large difference which can cause problems when taking measurements from the images of the substrate.

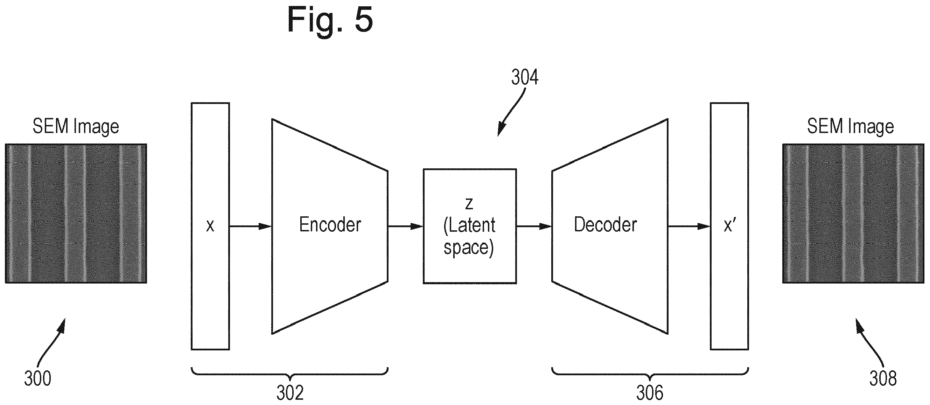

The method according to the present disclosure aims to address the above problems and enable more accurate measurement of structures on the substrate. Figure 5 illustrates schematically a method in accordance with an embodiment for removing an artefact from an image 300 of a semiconductor substrate. An image 300 of a structure on the semiconductor substrate is obtained in a first step. This may, for example, be performed by an SEM or any other suitable means. The image 300 is then encoded 302 into a latent space 304 to form a first encoding. Once in the latent space 304, an artefact vector, representative of an artefact in the image 300, is subtracted from the first encoding thereby forming a second encoding. The artefact vector may, for example, be representative of charge-induced artefacts in the image. The second encoding is decoded 306 to obtain a decoded image 308. Through removal of the artefact vector in the latent space 304, the decoded image 308 will no longer contain the artefact therein, or at least contain a reduced amount of artefact therein. Accordingly, with the artefact removed, measurements of structures on the decoded image 308 may be performed. These measurements may therefore be free of the influence of the artefacts in the original image 300.

A variational autoencoder network comprising an encoder and decoder may be pre-trained in order to perform the steps described above. Training of the autoencoder network, i.e. optimizing the weights of the encoder and decoder, may be achieved by encoding training images and decoding to the encodings with the aim being to obtain an output image that is as close as possible to the input image. The weightings may be adjusted accordingly to achieve this. This training may be performed using a plurality of training images, preferably a large number of images, with varying levels of artefact present therein. The training images may, for example, be obtained using an SEM or the images may be synthetically produced.

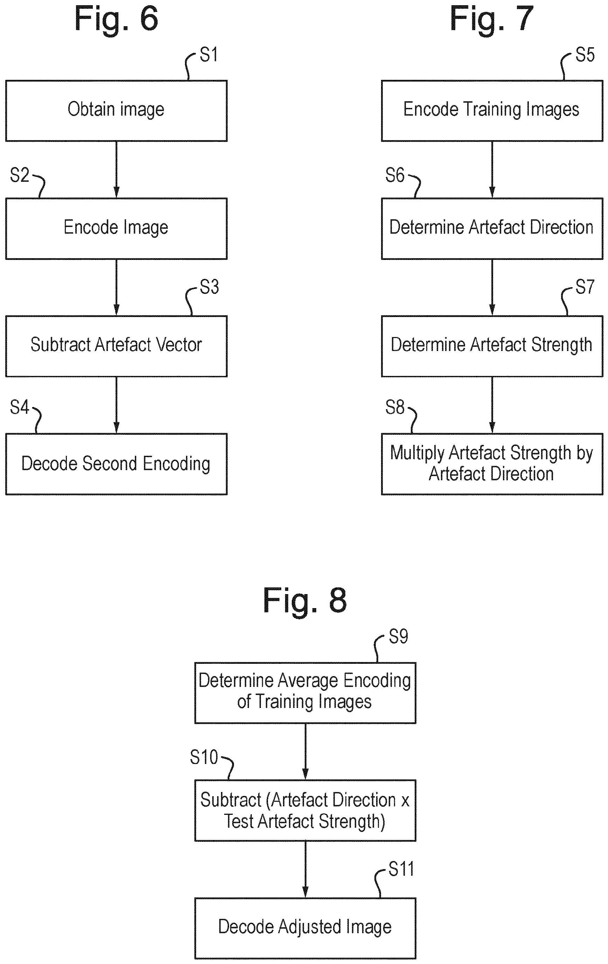

The exemplary method described above with respect to Figure 5 is also depicted in Figure 6, in the form of a flow chart. An image of a structure on the semiconductor substrate is obtained in step S1. Once the image is obtained, the image is then encoded into a latent space to form a first encoding in step S2. If the image is denoted as x' then the first encoding is given by:

$$z' = \text{encoder}(x') \tag{1}$$

Encoding the image may take a high-dimensional image to a descriptive low-dimensional latent space. Once the first encoding is formed, the artefact vector, represented by $\alpha u$, is subtracted in step S3 to form a second encoding z". This is shown mathematically as:

$$z'' = z' - \alpha u \tag{2}$$

With the artefact vector removed, the second encoding z" is then decoded in step S4 to provide a decoded image x". This is shown mathematically as:

$$x'' = \text{decoder}(z'') = \text{decoder}(\text{encoder}(x') - \alpha u) \tag{3}$$

This decoded image x" therefore has the artefact removed therefrom.

Figure 7 depicts a method for determining the artefact vector, which is used in step S3 as described above. According to this method, in step S5 a plurality of semiconductor substrate training images are encoded into the latent space. The plurality of training images may comprise any suitable images. For example, the plurality of training images may comprise multiple images of the same semiconductor substrate, for example, different locations on the same semiconductor substrate or images of different semiconductor substrates. The plurality of images may comprise at least two sets of images, a first set having a first level of the artefact present therein, and a second set having a second, higher level of the artefact present therein. For example, the first set of images may have a relatively small amount of SEM-induced charging present therein, and the second set of images may have a relatively large amount of SEM-induced charging present therein. The number of images in each set need not necessarily be large. This is further described with reference to the equations below. The first set of images may be represented by $(X_{+1})$ and the second set of images by $(X_{+2})$. The average encodings for each set are then determined by the following equations:

$$z_{+1} = E[\text{encoder}(x)], x \in X_{+1} \tag{4}$$

$$z_{+2} = E[\text{encoder}(x)], x \in X_{+2}, \tag{5}$$

where E is the expectation operator.

Once the average encodings for each of the training images in each set is determined, step S6 is performed in which the artefact direction in the latent space is determined. This may be achieved by normalizing a subtraction of the average encoding of the first set of images from the second set. This artefact direction is thus the unit length vector, u, given by equation:

$$u = \frac{z_{+2} - z_{+1}}{\|z_{+2} - z_{+1}\|} \tag{6}$$

The artefact strength is determined in step S7 and the artefact strength and direction are multiplied together to give the artefact vector in step S8. This artefact vector can then be used as described above in the method shown in Figure 6.

An exemplary method for determining the artefact strength is depicted in Figure 8. The method shown in Figure 8 is repeated for a range of different test artefact strength values. For each test artefact strengths value, the following method is performed. In step S9, an average encoding in the latent space of the plurality of training images is determined. Once the average encoding for each of the images has been determined, the artefact direction multiplied by the test artefact strength value is subtracted from the average encoding of the plurality of training images in step S10. This results in an adjusted encoding in which a 'test' artefact vector is subtracted. The adjusted encoding is then decoded in step S11 to provide an adjusted image. The above process is repeated for each value in the range of test artefact strength values. In order to determine which test artefact strength value most closely represents the actual artefact strength in the images, the adjusted images are analyzed and the artefact strength is determined to be the test artefact strength value for which the adjusted image corresponds to an optimized image. The analysis and the optimized image may depend on a number of factors depending on the type of artefact which is being removed.

In the exemplary case of removing SEM-charge induced artefacts, an optimized image may be an image which has maximum symmetry if the measured geometry is symmetric. Taking the case of the removal of SEM-charge induced artefacts, the artefact strength being determined in the method shown in Figure 8 may correspond to a charging strength. In this instance, in order to facilitate optimization at the end of the method shown in Figure 8, the plurality of training images used in the process may be selected to comprise images which have symmetric geometries. Through the use of such images, in the optimization in which determination of the test artefact strength which represents the actual artefact strength is performed, symmetry in the final adjusted image may be sought. A set of training images having symmetric geometries therein may be denoted by $X_{sym}$. For the set of images, $X_{sym}$ the method of Figure 8 may thus be formed and the adjusted may be analyzed for symmetry therein. The search for symmetry may effectively be a line search along the charging sensitive direction $\Delta z$, such that the symmetry of the decoded image is maximized. The steps of the method shown in Figure 8, and the optimization to determine the artefact strength which results in an adjusted image having maximum symmetry, is represented mathematically in the following equation in which $\alpha$ is the artefact strength:

$$\alpha = \underset{\alpha \in R}{\operatorname{argmax}} \, \text{symmetry}(\text{decoder}(E[\text{encoder}(x)] - \alpha u)), x \in X_{sym} \tag{7}$$

In the case of SEM-charge induced artefacts, the reason for performing the above optimization based on symmetry is because charging introduces asymmetry into images of otherwise symmetric patterns, as are typically present on semiconductor substrates. Accordingly, by minimizing the asymmetry, e.g. finding the artefact strength which when removed provides maximum symmetry, it is possible to find the length of the shift in the latent space which minimizes charging. These steps are helpful because it is difficult to have clean images without charging.

The optimization performed above for maximizing symmetry is merely one example of a type of optimization which may be performed to determine the artefact strength, and one which is particularly suited when determining the strength of a SEM-charge induced artefact. Any other appropriate optimization may be performed.

The artefact may be at least partially caused by noise in an image of the semiconductor substrate. In this instance, the same process as described above for SEM-charge induced artefacts may be carried out, except that instead of considering the symmetry of the adjusted images, the total variation may instead be considered. The total variation may be minimized in order to determine the artefact strength of a noise vector representative of noise within the image. Similarly to the process above for SEM-charge induced artefacts, a line search along the noise sensitive direction $\Delta z$ may be performed and the artefact strength $\alpha$ of the noise artefact may be determined to be the artefact strength $\alpha$ which provides an adjusted image having a minimum total variation. The method shown in Figure 8 and the optimization for reducing the total variation is shown mathematically in the following equation:

$$\alpha = \operatorname*{argmin}_{\alpha \in R} \mathrm{TV}(\mathrm{decoder}(E[\mathrm{encoder}(x)] - \alpha u)), x \in X \qquad (8)$$

It is known that noise increases the total variation of an image. Accordingly, by minimizing the total variation it may be possible to find the artefact strength for the noise artefact vector, e.g. the length of the shift in latent space, that minimizes noise. It is difficult to obtain images without any noise present and thus this technique provides a means for removing the noise from such images. Of course total variation is not the only measure that is indicative of noise in an image and any other measure of noisiness may equally be employed in the optimization described above.

A process similar to those described above may also be employed for removing artefacts which are the result of resist shrinkage. Determination of the artefact strength for the resist shrink vector, i.e. the artefact vector, in a particular set of images may be performed by using the method shown in Figure 8. The training images may also include the image from which a resist shrink artefact is to be removed. Similar to the methods described above, a line search in accordance with the method shown in Figure 8 is performed along the shrink sensitive direction $\Delta z$, such that a particular measure of shrink is minimized. One such measure that may be used is a measure of the area outside of the resist formed on the semiconductor substrate, which may be referred to as a complementary resist area (CRA). Resist shrink causes an increase in the area of the image which is not covered by resist. Such an area may be minimized to bring the area of the resist as close as possible to the actual area of the resist on the semiconductor substrate. In this case, an optimized image may correspond to an image in which the effect of resist shrink has been reduced. In such an example, the strength, $\alpha$, of the shrink vector may be determined according to the following equation

$$\alpha = \operatorname*{argmin}_{\alpha \in R} \mathrm{CRA}(\mathrm{decoder}(E[\mathrm{encoder}(x)] - \alpha u)), x \in X \qquad (9)$$

It is known that resist shrink increases the CRA of an image. Accordingly, by minimizing the CRA it may be possible to find the artefact strength for the shrink artefact vector that minimizes the artefact introduced by resist-shrink.

In any of the methods described above, the artefact strength may be determined from a set of training images which may comprise the image from which the artefact will be removed, i.e. the image of the semiconductor substrate. This advantageously ensures that the artefact level in the image of interest, from which the artefact ultimately needs to be removed, is comparable to the artefact level of the images of the training set. This may be employed when removing SEM-charge induced artefacts, noise induced artefacts or resist-shrink induced artefacts.

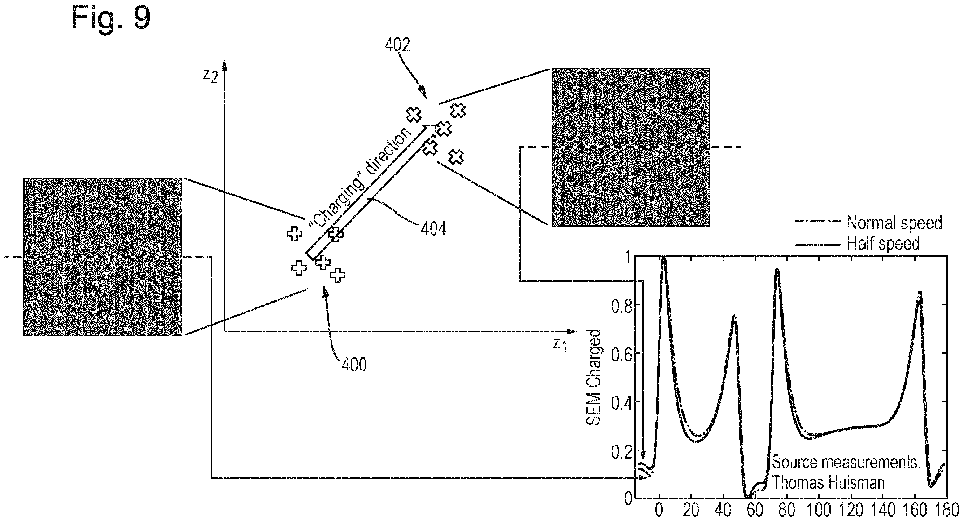

With reference to the methods described above in which two sets of images having different levels of encoding therein are used, Figure 9 shows a graph of the encodings of two sets of images into the latent space z. The crosses 400 represent the encodings of a first set of images with a lower level of artefact present therein and the crosses 402 represent the encodings of a second set of images with a higher level of artefact present therein. The arrow 404 represents the artefact vector for the artefact in the images encoded into the latent space. The image at the far left of Figure 9 is an image obtained with an SEM operating at normal scanning speed resulting in a relatively low level of artefact present therein. The image on the far right is an image obtained with an SEM operating at half speed resulting in a higher level of artefact present therein. In this case, the artefact of interest is the SEM-charge induced artefact. The graph on the bottom right of Figure 9 shows a normalized pixel intensity along the dashed line in the two images discussed above. This graph demonstrates how the pixel intensity for the half-speed scanning is more asymmetric than the pixel intensity with the normal-speed scanning, due to the presence of stronger charging effects.

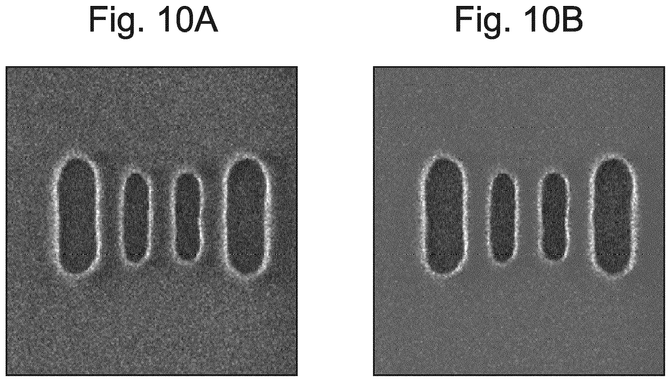

Figure 10A shows an image of a structure on a semiconductor substrate. The image shown in Figure 10A has artefacts present therein, thus impacting the accuracy of measurements made therefrom. Figure 10B shows the same image as Figure 10A, except with the artefacts removed through a technique disclosed herein. With the artefacts removed from the image, more accurate measurements of the structure on the semiconductor substrate can be made.

The training images used in the methods described above may be any suitable training images. The training images may comprise images of semiconductor substrates with artefacts present therein. The training images may comprise images of multiple different semiconductor substrates with artefacts present therein. Further, the training images may comprise synthetic images, i.e. images which have been manufactured. For example, the synthetic images may comprise reflections, crops or other processes performed on an initial set of images of one or more semiconductor substrates.

In the embodiments described above, a single type of artefact is subtracted in each case. However, a single image may comprise multiple artefacts present therein. Accordingly, the method may comprise subtracting a plurality of different artefact vectors from the latent space. For example, a charge-induced artefact vector and a noise artefact vector may be removed in order to remove both charging and noise from the image. Any combination of artefact vectors may be removed.

The metrology apparatus 140 shown in Figure 1 may comprise an imaging system configured to image a portion of a semiconductor substrate and it may further comprise an image analysis system configured to perform the method disclosed herein. Similarly, the SCS or any other suitable system may comprise the image analysis system configured to perform the method disclosed herein.

There is further disclosed herein a method of manufacture of a semiconductor substrate, the method comprising the steps of: manufacturing at least part of the semiconductor substrate; performing the method of removing an artefact from an image of a semiconductor substrate as disclosed herein; analyzing the decoded image to obtain a metric of the image; and comparing the metric to a target metric and taking remedial action when the metric does not meet the target metric. This manufacturing method may be performed by suitable parts of the apparatus shown in Figure 1.

The techniques disclosed herein can be used to improve metrology, for example SEM metrology, without compromising on throughput. Further, the techniques disclosed herein may be employed by existing commercial metrology products, for example SEM modelling products, in order to offer a fast solution for removing additional artefacts from the images obtained using the metrology process.

Advantageously the techniques disclosed herein do not necessarily require the existence of images which do not comprise artefacts therein in order to be able to determine the artefact vector. Instead, an optimization problem is solved in order to determine the length of the artefact vector.

Some of the techniques disclosed herein advantageously minimize, or even avoid, the need for other means for reducing the artefacts in images of semiconductor substrates. For example, it may no longer be necessary to: optimize the landing energy of an electron beam, coat the target with a conducting alloy, use faster scanning with lower charge dose, use more imaging frames, use opposing scan directions, perform multiple averaging, adjust electron dose per pixel, perform model-based extrapolation, or flood expose the target. All of these prior art techniques are known to have limitations, for example whilst some techniques reduce one type of artefact, they increase another type, or have other negative impacts such as reducing resolution or signal to noise ratio. Therefore by using the disclosed method for removing artefacts, it may be possible to obtain optimal images which have a reduced levels of artefacts present therein, potentially without negatively affecting the image in other ways, for example its resolution.

The techniques disclosed herein can reduce the complexity of SEM processes.

The techniques disclosed herein can be used in in-line measurements for control loops and wafer disposition.

While specific techniques have been described above, it will be appreciated that the disclosure may be practiced otherwise than as described.

An embodiment may include a computer program containing one or more sequences of machine-readable instructions configured to instruct various apparatus as depicted in Figure 1 to perform measurement and optimization steps and to control a subsequent exposure process as described above. This computer program may be executed, for example, within the control unit LACU or the supervisory control system SCS of Figure 1 or a combination of both. There may also be provided a data storage medium (e.g., semiconductor memory, magnetic or optical disk) having such a computer program stored therein.

Although specific reference may have been made above to optical lithography, it will be appreciated that the techniques disclosed herein may be used in other applications, for example imprint lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultraviolet (EUV) radiation (e.g., having a wavelength in the range of 1-100 nm), as well as particle beams, such as ion beams or electron beams. Implementations of scatterometers and other inspection apparatus can be made in UV and EUV wavelengths using suitable sources, and the present disclosure is in no way limited to systems using IR and visible radiation.

The term "lens", where the context allows, may refer to any one or combination of various types of optical components, including refractive, reflective, magnetic, electromagnetic and electrostatic optical components. Reflective components are likely to be used in an apparatus operating in the UV or EUV ranges.

As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

Aspects of the present disclosure are set out in the following numbered clauses:

1. A method for removing an artefact from an image of a semiconductor substrate, the method comprising:

obtaining an image of a structure on the semiconductor substrate;

encoding the image of the structure into a latent space thereby forming a first encoding;

subtracting an artefact vector, representative of an artefact in the image, from the encoding thereby forming a second encoding; and

decoding the second encoding to obtain a decoded image.

2. A method as claimed in clause 1, wherein the artefact vector is determined by:

encoding a plurality of semiconductor substrate training images into the latent space, wherein the plurality of training images comprises at least two sets of images, a first set having a first level of the artefact present therein and a second set having a second, higher level of the artefact present therein.

3. A method as claimed in clause 2, further comprising:

determining an average encoding of the first set of images and determining an average encoding of the second set of images;

determining an artefact direction by normalizing a subtraction of the average encoding of the first set from the second set;

determining an artefact strength; and

multiplying the artefact strength and the artefact direction to provide the artefact vector.

4. A method as claimed in clause 3, wherein the artefact strength is determined by:

for a plurality of the training images, and for each value in a range of test artefact strength values, performing the following steps:

determining an average encoding of the plurality of training images in the latent space;

subtracting the artefact direction multiplied by the test artefact strength value from the average encoding of the plurality of training images thereby forming an adjusted encoding; and

decoding the adjusted encoding to form an adjusted image;

wherein the artefact strength is determined to be a particular one of the test artefact strength values for which the adjusted image corresponds to an optimized image.

5. A method as claimed in clause 4, wherein the optimized image is an image having maximum symmetry.

6. A method as claimed in clause 5, wherein the plurality of training images are selected to comprise images having symmetric geometries therein.

7. A method as claimed in any one of clauses 4-6, wherein the optimized image is an image which has minimum total variation.

8. A method as claimed in any one of clauses 4-7, wherein the optimized image corresponds to an image in which the effect of resist shrink has been reduced.

9. A method as claimed in any one of claims claim 2-8, wherein the plurality of training images comprises the image of the semiconductor substrate which the artefact is to be removed from.

10. A method as claimed in any preceding clause, wherein the step of obtaining an image of a structure on the semiconductor substrate comprises obtaining an image using a scanning electron microscope.

11. A method as claimed in any preceding clause, wherein the artefact is at least partially caused by charging of the semiconductor substrate.

12. A method as claimed in any preceding clause, wherein the artefact is at least partially caused by noise in the image of the semiconductor substrate.

13. A method as claimed in any preceding clause, wherein the semiconductor substrate comprises a resist thereon and wherein the artefact is at least partially caused by resist shrink.

14. An inspection tool comprising:

an imaging system configured to image a portion of a semiconductor substrate; and

an image analysis system configured to:

obtain an image of a structure on the semiconductor substrate from the imaging system;

encode the image of the structure into a latent space thereby forming a first encoding;

subtract an artefact vector, representative of an artefact in the image, from the encoding thereby forming a second encoding; and

decode the second encoding to obtain a decoded image.

15. An inspection tool according to clause 14, wherein the artefact vector is determined by:
encoding a plurality of semiconductor substrate training images into the latent space, wherein the plurality of training images comprises at least two sets of images, a first set having a first level of the artefact present therein and a second set having a second, higher level of the artefact present therein.

16. An inspection tool according to clause 15, further comprising:

determining an average encoding of the first set of images and determining an average encoding of the second set of images;
determining an artefact direction by normalizing a subtraction of the average encoding of the first set from the second set;
determining an artefact strength; and
multiplying the artefact strength and the artefact direction to provide the artefact vector.

17. An inspection tool according to clause 16, wherein the artefact strength is determined by:

for a plurality of the training images, and for each value in a range of test artefact strength values, performing the following steps:

determining an average encoding of the plurality of training images in the latent space;
subtracting the artefact direction multiplied by the test artefact strength value from the average encoding of the plurality of training images thereby forming an adjusted encoding; and
decoding the adjusted encoding to form an adjusted image;

wherein the artefact strength is determined to be a particular one of the test artefact strength values for which the adjusted image corresponds to an optimized image.

18. An inspection tool according to clause 17, wherein the optimized image is an image having maximum symmetry.
19. An inspection tool according to clause 18, wherein the plurality of training images are selected to comprise images having symmetric geometries therein.
20. An inspection tool according to any one of clauses 17-19, wherein the optimized image is an image which has minimum total variation.
21. An inspection tool according to any one of clauses 17-20, wherein the optimized image corresponds to an image in which the effect of resist shrink has been reduced.
22. An inspection tool according to any one of clauses 15-21, wherein the plurality of training images comprises the image of the semiconductor substrate which the artefact is to be removed from.
23. An inspection tool according to any one of clauses 14-22, wherein the imaging system comprises a scanning electron microscope.
24. An inspection tool according to any one of clauses 14-23, wherein the artefact is at least partially caused by charging of the semiconductor substrate.
25. An inspection tool according to any one of clauses 14-24, wherein the artefact is at least partially caused by noise in the image of the semiconductor substrate.
26. An inspection tool according to any one of clauses 14-25, wherein the semiconductor substrate comprises a resist thereon and wherein the artefact is at least partially caused by resist shrink.
27. A method of manufacture of a semiconductor substrate, the method comprising the steps of:

manufacturing at least part of the semiconductor substrate;
obtaining an image of a structure on the semiconductor substrate;
encoding the image of the structure into a latent space thereby forming a first encoding;
subtracting an artefact vector, representative of an artefact in the image, from the encoding thereby forming a second encoding;
decoding the second encoding to obtain a decoded image;
analyzing the decoded image to obtain a metric of the image; and
comparing the metric to a target metric and taking remedial action when the metric does not meet the target metric.

28. A method of manufacture according to clause 27, wherein the artefact vector is determined by:
encoding a plurality of semiconductor substrate training images into the latent space, wherein the plurality of training images comprises at least two sets of images, a first set having a first level of the artefact present therein and a second set having a second, higher level of the artefact present therein.

29. A method of manufacture according to clause 28, further comprising determining an average encoding of the first set of images and determining an average encoding of the second set of images;

determining an artefact direction by normalizing a subtraction of the average encoding of the first set from the second set;

determining an artefact strength; and

multiplying the artefact strength and the artefact direction to provide the artefact vector.

30. A method of manufacture according to clause 29, wherein the artefact strength is determined by:

for a plurality of the training images, and for each value in a range of test artefact strength values, performing the following steps:

determining a an average encoding of the plurality of training images in the latent space;
subtracting the artefact direction multiplied by the test artefact strength value from the average encoding of the plurality of training images thereby forming an adjusted encoding; and
decoding the adjusted encoding to form an adjusted image;

wherein the artefact strength is determined to be a particular one of the test artefact strength values for which the adjusted image corresponds to an optimized image.

31. A method of manufacture according to clause 30, wherein the optimized image is an image having maximum symmetry.

32. A method of manufacture according to clause 31, wherein the plurality of training images are selected to comprise images having symmetric geometries therein.

33. A method of manufacture according to any one of clauses 27-32, wherein the optimized image is an image which has minimum total variation.

34. A method of manufacture according to any one of clauses 27-33, wherein the optimized image corresponds to an image in which the effect of resist shrink has been reduced.

35. A method of manufacture according to any one of clauses 27-34, wherein the plurality of training images comprises the image of the semiconductor substrate which the artefact is to be removed from.

36. A method of manufacture according to any one of clauses 27-35, wherein the step of obtaining an image of a structure on the semiconductor substrate comprises obtaining an image using a scanning electron microscope.

37. A method of manufacture according to any one of clauses 27-36, wherein the artefact is at least partially caused by charging of the semiconductor substrate.

38. A method of manufacture according to any one of clauses 27-37, wherein the artefact is at least partially caused by noise in the image of the semiconductor substrate.

39. A method of manufacture according to any one of clauses 29-38, wherein the semiconductor substrate comprises a resist thereon and wherein the artefact is at least partially caused by resist shrink.

The breadth and scope of the present techniques disclosed herein should not be limited by any of the above-described exemplary embodiments, but should be defined only in accordance with the following claims and their equivalents.

**Claims**

1. An inspection tool comprising:

an imaging system configured to image a portion of a semiconductor substrate; and
an image analysis system configured to:

obtain an image of a structure on the semiconductor substrate from the imaging system;
encode the image of the structure into a latent space thereby forming a first encoding;
subtract an artefact vector, representative of an artefact in the image, from the encoding thereby forming a second encoding; and
decode the second encoding to obtain a decoded image.

**2.** An inspection tool as claimed in claim 1, wherein the artefact vector is determined by:
encoding a plurality of semiconductor substrate training images into the latent space, wherein the plurality of training images comprises at least two sets of images, a first set having a first level of the artefact present therein and a second set having a second, higher level of the artefact present therein.

**3.** An inspection tool as claimed in claim 2, further comprising:

determining an average encoding of the first set of images and determining an average encoding of the second set of images;
determining an artefact direction by normalizing a subtraction of the average encoding of the first set from the second set;
determining an artefact strength; and
multiplying the artefact strength and the artefact direction to provide the artefact vector.

**4.** An inspection tool as claimed in claim 3, wherein the artefact strength is determined by:

for a plurality of the training images, and for each value in a range of test artefact strength values, performing the following steps:

determining an average encoding of the plurality of training images in the latent space;
subtracting the artefact direction multiplied by the test artefact strength value from the average encoding of the plurality of training images thereby forming an adjusted encoding; and
decoding the adjusted encoding to form an adjusted image;

wherein the artefact strength is determined to be a particular one of the test artefact strength values for which the adjusted image corresponds to an optimized image.

**5.** An inspection tool as claimed in claim 4, wherein the optimized image is an image having maximum symmetry.

**6.** An inspection tool as claimed in claim 5, wherein the plurality of training images are selected to comprise images having symmetric geometries therein.

**7.** An inspection tool as claimed in claim 4, wherein the optimized image is an image which has minimum total variation.

**8.** An inspection tool as claimed in claim 4, wherein the optimized image corresponds to an image in which the effect of resist shrink has been reduced.

**9.** An inspection tool as claimed in claim 2, wherein the plurality of training images comprises the image of the semiconductor substrate which the artefact is to be removed from.

**10.** An inspection tool as claimed in claim 1, wherein the imaging system comprises a scanning electron microscope.

**11.** An inspection tool as claimed in claim 1, wherein the artefact is at least partially caused by charging of the semiconductor substrate.

**12.** An inspection tool as claimed in claim 1, wherein the artefact is at least partially caused by noise in the image of the semiconductor substrate.

**13.** An inspection tool as claimed in claim 1, wherein the semiconductor substrate comprises a resist thereon and wherein the artefact is at least partially caused by resist shrink.

**14.** A method for removing an artefact from an image of a semiconductor substrate, the method comprising:

obtaining an image of a structure on the semiconductor substrate;
encoding the image of the structure into a latent space thereby forming a first encoding;
subtracting an artefact vector, representative of an artefact in the image, from the encoding thereby forming a second encoding; and
decoding the second encoding to obtain a decoded image.

**15.** A method of manufacture of a semiconductor substrate, the method comprising the steps of:

manufacturing at least part of the semiconductor substrate;
performing the method as claimed in claim 14;
analyzing the decoded image to obtain a metric of the image; and
comparing the metric to a target metric and taking remedial action when the metric does not meet the target metric.

# Fig. 1

## Fig. 2A

## Fig. 2B

## Fig. 3A

## Fig. 3B

## Fig. 4A

## Fig. 4B

# Fig. 5

EP 3 889 684 A1

# Fig. 6

S1

Obtain image

S2

Encode Image

S3

Subtract Artefact Vector

S4

Decode Second Encoding

# Fig. 7

S5

Encode Training Images

S6

Determine Artefact Direction

S7

Determine Artefact Strength

S8

Multiply Artefact Strength by
Artefact Direction

# Fig. 8

S9

Determine Average Encoding
of Training Images

S10

Subtract (Artefact Direction x
Test Artefact Strength)

S11

Decode Adjusted Image

Fig. 9

## Fig. 10A

## Fig. 10B

Europäisches
Patentamt

European
Patent Office

Office européen
des brevets

# EUROPEAN SEARCH REPORT

Application Number

EP 20 16 7449

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2019/287230 A1 (LU SHAOYU [US] ET AL) 19 September 2019 (2019-09-19) * paragraphs [0049] - [0060], [0064], [0071] - [0076]; figures 2-9 * ----- | 1-15 | INV. G03F7/20 G01N21/956 G06T7/00 |
| A | US 2019/005629 A1 (SHARMA SAURABH [IN] ET AL) 3 January 2019 (2019-01-03) * paragraphs [0081] - [0085]; claims 1,2; figures 2-5 * ----- | 1-15 | |
| A | US 2018/330511 A1 (HA THANH HUY [US] ET AL) 15 November 2018 (2018-11-15) * paragraphs [0100] - [0102] * ----- | 1-15 | |

TECHNICAL FIELDS
SEARCHED (IPC)

G03F
G01N
G06T

The present search report has been drawn up for all claims

| Place of search | Date of completion of the search | Examiner |
|---|---|---|
| Munich | 30 September 2020 | Roesch, Guillaume |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 20 16 7449

This annex lists the patent family members relating to the patent documents cited in the above-mentioned European search report.
The members are as contained in the European Patent Office EDP file on
The European Patent Office is in no way liable for these particulars which are merely given for the purpose of information.

30-09-2020

| Patent document cited in search report | Publication date | Patent family member(s) | Publication date |
|---|---|---|---|
| US 2019287230 A1 | 19-09-2019 | TW 201946089 A<br>US 2019287230 A1<br>WO 2019182922 A1 | 01-12-2019<br>19-09-2019<br>26-09-2019 |
| US 2019005629 A1 | 03-01-2019 | US 2019005629 A1<br>WO 2019006221 A1 | 03-01-2019<br>03-01-2019 |
| US 2018330511 A1 | 15-11-2018 | CN 110603625 A<br>KR 20190141787 A<br>TW 201901113 A<br>US 2018330511 A1<br>WO 2018208869 A2<br>WO 2018208871 A1 | 20-12-2019<br>24-12-2019<br>01-01-2019<br>15-11-2018<br>15-11-2018<br>15-11-2018 |

EPO FORM P0459

For more details about this annex : see Official Journal of the European Patent Office, No. 12/82

**EP 3 889 684 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012008127 A1